# EUROPÄISCHE PATENTSCHRIFT

(11) **EP 0 459 137 B1**
(45) Veröffentlichungstag und Bekanntmachung des Hinweises auf die Patenterteilung: **05.07.2000**
(21) Anmeldenummer: 91106331.1
(22) Anmeldetag: 19.04.1991
(51) Int. Cl.: H01J 37/34, C23C 14/34

(54) **Vorrichtung zur Beschichtung von Substraten**
Device for coating of substrates
Dispositif pour revêtement de substrats

(30) Priorität: 28.05.1990 DE 4017111
(43) Veröffentlichungstag der Anmeldung: 04.12.1991
(73) Patentinhaber: HAUZER INDUSTRIES BV, 5900 AE Venlo (NL)
(72) Erfinder: Münz, Wolf-Dieter, Dr., NL-5913 RV Venlo (NL); Hauzer, Fransiscus J.M., NL-5941 CV Velden (NL); Buil, Boudewijn J.A., NL-5951 CV Velden (NL); Schulze, Dietmar, Dr., O-8060 Dresden (DE); Tietema, Roel, NL-5926 SK Venlo (DE)
(74) Vertreter: Manitz, Finsterwald & Partner

(56) Entgegenhaltungen:
- EP-A- 0 205 874
- EP-A- 0 404 973
- DE-A- 3 812 379
- US-A- 4 309 266
- US-A- 4 724 058
- PATENT ABSTRACTS OF JAPAN, unexamined applications, C Field, Band 7, Nr. 175, 03. August 1983 THE PATENT OFFICE JAPANESE GOVERNMENT Seite 92 C 179

## Beschreibung

Die Erfindung betrifft eine Vorrichtung zur Beschichtung von Substraten unter Verwendung eine Bogenentladung und einer Kathodenzerstäubung, mit einem evakuierbaren Gefäß, in dem zumindest ein Target, eine zugehörige Anode sowie ein Substratträger angeordnet und die zugehörigen Strom- und Spannungsversorgungen vorgesehen sind und jedem Target eine Magnetanordnung zugeordnet ist.

In der nicht vorveröffentlichten deutschen Patentanmeldung P 39 41 918.5 (EP-A-0404973) wird ein Verfahren zur Beschichtung von Substraten beschrieben, bei welchem die aufzubringende Schicht durch auf das betreffende Substrat auftreffende kondensierende Teilchen eines mittels einer Gasentladung erzeugten Plasmas hergestellt wird. Charakteristisch für dieses Verfahren ist, daß sowohl eine Bogenentladungsentdampfung als auch eine Kathodenzerstäubung vorgenommen und dabei die Bogenentladungsverdampfung vor der Kathodenzerstäubung durchgeführt wird.

Während der Bogenentladungsverdampfung wird das Substrat zunächst mit Ionen derart optimierter hoher Energie und Ionenstromdichte beschossen, daß die Substratoberfläche durch Ionenätzung gereinigt und teilweise abgetragen wird. Ferner wird während dieser Bogenentladungsverdampfung vorzugsweise eine Verankerung der aufzubauenden Schicht im Substratmaterial bewirkt, und unmittelbar nach der Ausbildung der Verankerung erfolgt dann eine Beschichtung mittels der Kathoden- oder Magnetronzerstäubung.

Aufgabe der Erfindung ist es, eine Vorrichtung zu schaffen, die es gestattet, insbesondere das vorstehend beschriebene Verfahren in besonders wirtschaftlicher Weise, das heißt unter Minimierung des gerätetechnischen Aufwands zu realisieren.

Gelöst wird diese Aufgabe durch die Vorrichtungen gemäß Anspruch 1 und 2. Vorteilhafte Ausführungsformen des Erfindung sind in den abhängigen Ansprüchen definiert.

Auf diese Weise gelingt es, im Targetbereich bzw. im Bereich der Targetoberfläche während der Phase der Bogenentladung ein Magnetfeld mit einer zur Targetoberfläche parallel verlaufenden Magnetfeldkomponente im Bereich von 10 bis 250 Oe, insbesondere 10 bis 50 Oe zu erzeugen, während in der Phase der Bogenentladung die entsprechende Komponente Werte im Bereich von 50 bis 500 Oe, insbesondere 100 bis 250 Oe aufweist.

Der Abstand der Magnetanordnung zum Target liegt in der Phase des Bogenentladungsbetriebs im Bereich von 10 bis 20 cm.

Nach einer Ausgestaltung der Erfindung kann das Target von einer elektromagnetischen Ringspule umgeben sein. Diese elektromagnetische Spule ist insbesondere in Betrieb während der Phase der Kathodenzerstäubung, aber sie kann auch in der Phase der Bogenentladung eingesetzt werden, um die sich auf dem Target ausbildende Bogenspur zu beeinflussen und auf diese Weise die Standzeit des Targets zu erhöhen.

Die erfindungsgemäße Vorrichtung wird besonders vorteilhaft verwendet zur Herstellung von Nitriden, Carbonitriden sowie Carbiden von Titan, Zircon, Hafnium, Tantal, Niob, Aluminium und deren binären und ternären Mischungen.

Besonders vorteilhafte Ausgestaltungen der Erfindung sind in den Unteransprüchen angegeben.

Die Erfindung wird nachfolgend unter Bezugnahme auf die Zeichnung näher erläutert; in der Zeichnung zeigt:
- Figur 1: eine schematische Darstellung einer ersten Ausführungsform einer Vorrichtung nach der Erfindung,
- Figur 2: eine ebenfalls schematische Darstellung einer zweiten Ausführungsform der Erfindung, und
- Figur 3: eine schematische Draufsicht des Targets mit zugehörigen Versorgungen.

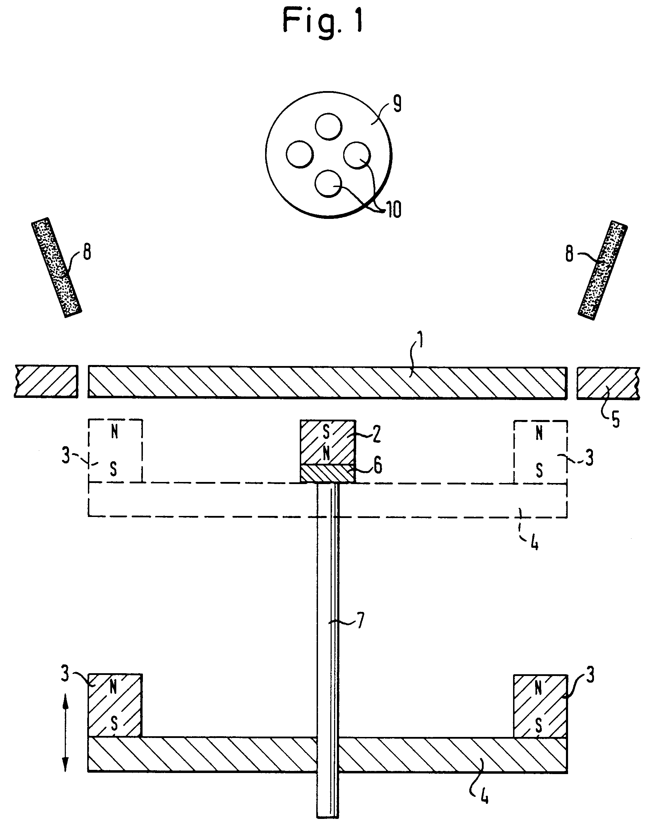

Figur 1 zeigt ein erstes Beispiel eines Arc-Magnetrons nach der Erfindung. Dabei ist einem Target 1 unmittelbar benachbart ein Mittelpol-Permanentmagnet 2 zugeordnet, der auf einem stabförmigen Träger 7 aus magnetisch neutralem Material unter Zwischenschaltung eines Distanzelements bzw. Spacers 6 aus ebenfalls magnetisch neutralem Material, zum Beispiel Kupfer oder Aluminium, angebracht bzw. befestigt ist. Durch diesen Mittelpol-Permanentmagneten 2, der gemäß diesem Ausführungsbeispiel ortsfest ist und bezüglich des Targets 1 nur einen geringen Abstand aufweist, wird im Targetbereich ein Magnetfeld erzeugt, das den Betrieb der Vorrichtung im Modus der Bogenentladung innerhalb des evakuierten Gefäßes 5 zuläßt.

Im Gefäß 5 befindet sich neben einer schematisch angedeuteten, für die Bogenentladung benötigten Anode 8 ein Substratträger 9, der verschiebbar oder rotierbar ausgebildet sein kann und zur Halterung der zu beschichtenden Substrate 10 dient.

Zusätzlich zu dem Mittelpol-Permanentmagnet 2 sind mit radialem Abstand zu dem Mittelpol-Permanentmagnet 2 Rand-Permanentmagneten 3 vorgesehen, die über eine Trägerplatte 4 magnetisch kurzgeschlossen sind. Die Rand-Permanentmagnete 3 sind bezüglich des Targets 1 im Vergleich zum Mittelpol-Permanentmagneten 2 entgegengesetzt gepolt.

Diese Rand-Permanentmagnetanordnung kann entsprechend dem dargestellten Doppelpfeil in Axialrichtung verfahren werden, wozu die Trägerplatte 4 eine Mittelöffnung aufweist, durch die sich der Trägerstab 7 für den Mittelpol-Permanentmagneten 2 erstreckt, so daß eine Relativbewegung zwischen dem Mittelpol-Permanentmagneten 2 und den Rand-Permanentmagneten 3 möglich ist.

Die Rand-Permanentmagnetanordnung 2, 4 wird während der Bogenentladung in die mit durchgezogenen Linien gezeichnete unwirksame Position gebracht. Während der Phase der Kathodenzerstäubung nimmt die Rand-Permanentmagnetanordnung die gestrichelt gezeichnete Position benachbart dem Target 1 ein und wirkt dabei mit dem Mittelpol-Permanentmagneten 2 unter Ausbildung eines ausgeprägten tunnelförmigen Magnetfeldes im Bereich der Targetoberfläche zusammen.

Da der Mittelpol-Permanentmagnet 2 durch den Spacer 6 von der Rand-Permanentmagnetanordnung 3 getrennt ist, ergibt sich dabei eine vorteilhaft unbalancierte, äußerst wirksame Magnetronanordnung, die zu einem günstigen, gleichmäßigen Erosionsprofil führt.

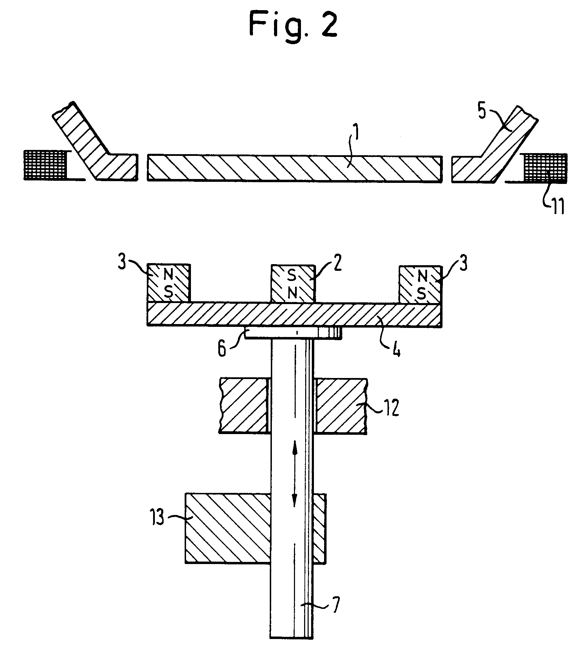

Die in Figur 2 gezeigte Ausführungsvariante besitzt gegenüber der Ausführungsform nach Figur 1 den Vorteil einer noch größeren Einfachheit, ohne daß dabei die Wirksamkeit der Permanentmagnetanordnung im Bogenentladungs- oder Kathodenzerstäubungsbetrieb störend beeinträchtigt werden würde.

Bei dieser Ausführungsform ist der Mittelpol-Permanentmagnet 2 gemeinsam mit den Rand-Permanentmagneten 3 axial verfahrbar, so daß der Mittelpol-Permanentmagnet 2 und die Rand-Permanentmagneten 3 auf der gleichen, einen magnetischen Kurzschluß bewirkenden Trägerplatte 4 angeordnet sein können. Das axiale Verfahren dieser Magnetanordnung erfolgt wiederum über einen Trägerstab 7, der in einer schematischen Führung 12 gelagert und über eine Antriebseinheit 13 axial verfahrbar ist.

Im Bereich des Targets 1 ist eine elektromagnetische Ringspule vorgesehen, die in bekannter Weise während der Kathodenzerstäubung in Betrieb gesetzt ist, während der Phase der Bogenentladung jedoch außer Betrieb oder so angesteuert sein kann, daß sie die sich ausbildende Bogenspur beeinflußt und damit zu einer Erhöhung der Standzeit des Targets 1 beiträgt.

In der in Figur 2 gezeigten Position, in der die Permanentmagnetanordung 2, 3 bezüglich des Targets 1 einen vergleichsweise großen Abstand aufweist, reicht das sich im Targetbereich ausbildende Streufeld aus, um den Betrieb der Vorrichtung im Modus der Bogenentladung zu gewährleisten. Wird die Permanentmagnetanordnung axial nach oben gefahren und in die unmittelbare Nähe des Targets 1 gebracht, kann die Kathodenzerstäubung durchgeführt werden.

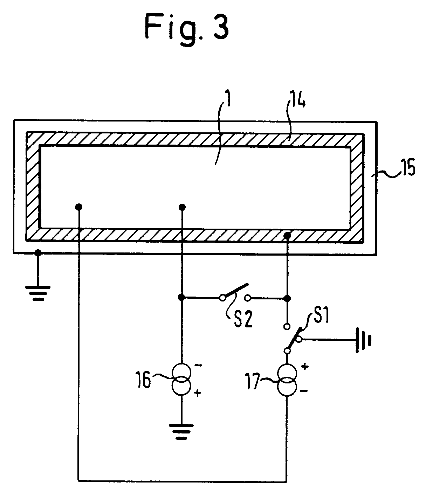

Figur 3 zeigt eine schematische Draufsicht auf ein Target 1, das mit einem bezüglich des Targets 1 isoliert angebrachten Bornitrid-Begrenzungsring 14 sowie einem Plasmaschild 15, das an Masse liegt, versehen ist.

Eine Magnetronversorgung 16 liegt mit ihrem positiven Pol an Masse und mit ihrem negativen Pol an dem Target 1, während eine Bogenversorgung 17 mit ihrem negativen Pol am Target 1 liegt und bezüglich ihres positiven Pols über einen Schalter S1 umschaltbar ist zwischen Masse und dem Bornitrid-Begrenzungsring 14. Während des Zündvorgangs ist der positive Pol über über den Schalter S1 mit dem Bornitrid-Begrenzungsring 14 verbunden, und nach erfolgter Zündung wird der Schalter S1 umgelegt, so daß der positive Pol der Bogenversorgung 17 während des Normalbetriebs an Masse liegt.

Beim Übergang vom Bogenbetrieb zum Magnetronbetrieb kann zur Verhinderung von Bogenentladungen in dem Spalt zwischen dem Begrenzungsring 14 und dem Target 1 der Bornitrid-Begrenzungsring 14 über einen Schalter S2 auf das Kathodenpotential bzw. Targetpotential gelegt werden. Der Schalter S2 ermöglicht somit eine Potentialtrennung des Bornitrid-Begrenzungsrings.

Nachfolgend werden bevorzugte Parameter bzw. Parameterbereiche von Kenngrößen der erfindungsgemäßsen Vorrichtung für den Betriebsmodus Bogenentladung und den Betriebsmodus Kathodenzerstäubung angegeben.

Betriebsmodus Bogenentladung:

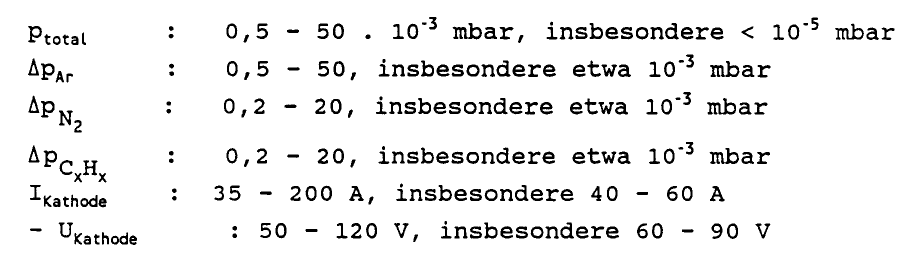

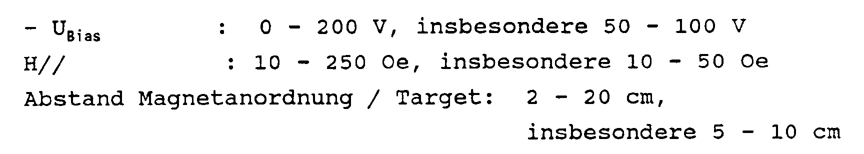

Betriebsmodus Kathodenzerstäubung:

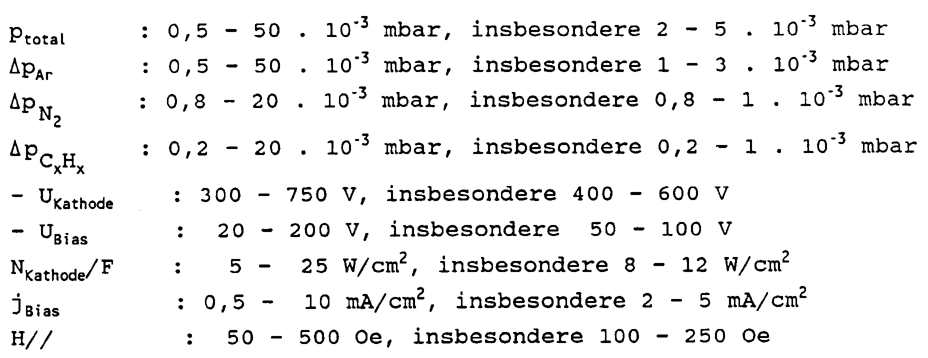

Bei diesen Parametern wird unter pₜₒₜₐₗ die Summe aller Partialdrücke im evakuierbaren Gefäß verstanden, und die Größe H// bezeichnet die Größe der zur Targetoberfläche parallelen Feldkomponente.

Die Größe N bezeichnet die Leistungsdichte an der Kathode, und mit j_{Bias} wird die Stromdichte am Substrat bezeichnet.

Die angegebenen Parameterwerte ermöglichen es auch, die Abstände zwischen dem Target und der Magnetanordnung im Hinblick auf das Erreichen eines Optimums zu wählen und die Magnetanordnung selbst im Hinblick auf ein bestmögliches Ergebnis zu dimensionieren.

## Patentansprüche

1. Vorrichtung zur Beschichtung von Substraten (10) unter Verwendung einer Bogenentladung und einer Kathodenzerstäubung, mit einem evakuierbaren Gefäß (5), in dem zumindest ein Target (1), eine zugehörige Anode (8) sowie ein Substratträger (9) angeordnet und die zugehörigen Strom- und Spannungsversorgungen vorgesehen sind und jedem Target (1) eine Magnetanordnung (2, 3) zugeordnet ist, wobei die Magnetanordnung aus einem Mittelpol-Permanentmagneten (2) und diesen mit Abstand umgebenden, eintgegengesetzt gepolten Rand-Permanentmagneten (3) besteht,
dadurch **gekennzeichnet,**
daß der Mittelpol-Permanentmagnet (2) bezüglich des Targets (1) in einer festen, dem Target (1) benachbarten Position angebracht ist, während die Rand-Permanentmagneten (3) zusammen mit einer Trägerplatte (4) relativ zum Target (1) und zum Mittelpol-Permanentmagneten (2) axial derart verschiebbar gelagert sind, daß im Targetbereich in einer ersten, dem Target (1) benachbarten Position ein eine Kathoden- oder Magnetronzerstäubung ermöglichendes Magnetfeld und in einer zweiten, bezüglich des Targets (1) beabstandeten Position ein eine Bogenentladung ermöglichendes Magnetfeld erzeugt wird.

2. Vorrichtung zur Beschichtung von Substraten (10) unter Verwendung einer Bogenentladung und einer Kathodenzerstäubung, mit einem evakuierbaren Gefäß (5), in dem zumindest ein Target (1), eine zugehörige Anode (8) sowie ein Substratträger (9) angeordnet und die zugehörigen Strom- und Spannungsversorgungen vorgesehen sind und jedem Target (1) eine Magnetanordnung (2, 3) zugeordnet ist, wobei die Magnetanordnung aus einem Mittelpol-Permanentagneten (2) und diesen mit Abstand umgebenden, entgegengesetzt gepolten Rand-Permanentmagneten (3) besteht, der Mittelpol-Permanentmagnet (2) magnetisch weniger wirksam als die Rand-Permanentmagneten (3) ausgebildet ist und die Rand-Permanentagneten (3) und der Mittelpol-Permanentmagnet (2) auf einer einen magnetischen Kurschluß bewirkenden Trägerplatte (4) angeordnet sind, wobei die die Magnetanordnung (2, 3) aufweisende Trägerplatte (4) mittels eines Trägerstabs (7), der unter Zwischenschaltung eines Distanzelementes (6) aus magnetisch neutralem Material mit der Trägerplatte (4) verbunden ist, relativ zum zugehörigen Target (1) derart verschiebbar gelagert ist, daß im Targetbereich in einer ersten, dem Target (1) benachbarten Position ein eine Kathodenzerstäubung ermöglichendes Magnetfeld und in einer zweiten, bezüglich des Targets beabstandeten Position ein eine Bogenentladung ermöglichendes Magnetfeld erzeugt wird.

3. Vorrichtung nach Anspruch 1,
dadurch **gekennzeichnet,**
daß der Mittelpol-Permanentmagnet (2) und die Rand-Permanentmagneten (3) magnetisch voneinander getrennt sind und dazu vorzugsweise zwischen der Trägerplatte (4) und dem Mittelpol-Permanentmagneten (2) ein Distanzelement (6) aus magnetisch neutralem Material angeordnet ist.

4. Vorrichtung Anspruch 1,
dadurch **gekennzeichnet,**
daß der Mittelpol-Permanentmagnet (2) magnetisch weniger wirksam als die Rand-Permanentmagneten (3) ausgebildet ist.

5. Vorrichtung nach einem der vorhergehenden Ansprüche,
dadurch **gekennzeichnet,**
daß das Target (1) von einer in Abhängigkeit vom jeweiligen Betriebsmodus ansteuerbaren elektromagnetischen Spule umgeben ist.

6. Vorrichtung nach einem der vorhergehenden Ansprüche,
dadurch **gekennzeichnet,**
daß der den beiden Betriebspositionen entsprechende Abstand zwischen dem Target (1) und der Magnetanordnung (2, 3) im Bereich von 10 bis 20 cm gelegen ist.

7. Vorrichtung nach einem der vorhergehenden Ansprüche,
dadurch **gekennzeichnet,**
daß die parallel zur Targetoberfläche verlaufende Komponente des Magnetfelds bei der Bogenentladung im Bereich von 10 bis 250, insbesondere 10 bis 50 Oe liegt.

8. Vorrichtung nach einem der vorhergehenden Ansprüche,
dadurch **gekennzeichnet,**
daß die parallel zur Targetoberfläche verlaufende Komponente des Magnetfelds bei der Kathodenzerstäubung im Bereich von 50 bis 500, insbesondere 100 bis 250 Oe liegt.

9. Vorrichtung nach einem der vorhergehenden Ansprüche,
dadurch **gekennzeichnet,**
daß die Targetfläche von einem bezüglich des Targets isolierten Bornitrid-Begrenzungsring (14) beim Übergang auf den Magnetronbetrieb zur Verhinderung von Bogenentladungen auf Kathodenpotential gelegt wird.

10. Vorrichtung nach einem oder mehreren der vorhergehenden Ansprüche,
dadurch **gekennzeichnet,**
daß die Anode vom Anlagenrezipienten gebildet ist.

## Claims

1. Apparatus for coating substrates (10) using an arc discharge and a cathode sputtering process, the apparatus comprising a chamber (5) which can be evacuated and in which are arranged at least one target (1), an associated anode (8) and also a substrate carrier (9), wherein associated current and voltage supplies are provided and a magnet arrangement (2, 3) is associated with each target (1) and wherein the magnet arrangement comprises a centre pole permanent magnet (2) and oppositely poled permanent edge magnets (3) surrounding and spaced from the centre pole permanent magnet, characterised in that the centre pole permanent magnet (2) is mounted relative to the target (1) in a fixed position adjacent to the target (1) while the permanent edge magnets (3) together with a carrier plate (4) are axially displaceably mounted relative to the target (1) and to the centre pole permanent magnet (2) in such a way that, in a first position adjacent the target, a magnetic field is generated in the target region which makes a cathode sputtering process possible and, in a second position spaced relative to the target (1), a magnetic field is generated which makes an arc discharge possible.

2. Apparatus for coating substrates (10) using an arc discharge and a cathode sputtering process, the apparatus comprising a chamber (5) which can be evacuated and in which are arranged at least one target (1), an associated anode (8) and also a substrate carrier (9), wherein associated current and voltage supplies are provided and a magnet arrangement (2, 3) is associated with each target (1), wherein the magnet arrangement comprises a centre pole permanent magnet (2) and oppositely poled permanent edge magnets (3) surrounding and spaced from the centre pole permanent magnet, wherein the centre pole permanent magnet (2) is made magnetically less effective than the permanent edge magnets (3) and the permanent edge magnets (3) and the centre pole permanent magnet (2) are arranged on a carrier plate (4) which brings about a magnet short circuit, and wherein the carrier plate (4) having the magnet arrangement (2, 3) is displaceably mounted relative to the associated target (1) by means of a carrier rod (7), which is connected to the carrier plate (4) through the intermediary of a spacer element (6) of magnetically neutral material, such that in the target region, in a first position adjacent to the target (1), there is produced a magnetic field making a cathode sputtering process possible and, in a second position, spaced relative to the target (1) a magnetic field is generated which makes an arc discharge possible.

3. Apparatus in accordance with claim 1, characterized in that the centre pole permanent magnet (2) and the permanent edge magnets (3) are magnetically separated from one another and in that a spacer element (6) of magnetically neutral material is preferably arranged between the carrier plate (4) and the centre pole permanent magnet (2).

4. Apparatus in accordance with claim 1, characterized in that the centre pole permanent magnet (2) is made magnetically less effective than the permanent edge magnets (3).

5. Apparatus in accordance with one of the preceding claims, characterized in that the target (1) is surrounded by an electromagnetic coil which can be controlled in dependence on the respective operating mode.

6. Apparatus in accordance with one of the preceding claims, characterized in that the distance between the target (1) and the magnet arrangement (2, 3) corresponding to the two operating positions, lies in the range from 10 to 20 cm.

7. Apparatus in accordance with one of the preceding claims, characterized in that the component of the magnetic field extending parallel to the target surface lies in the arc discharge process in the range from 10 to 250 Oe, in particular from 10 to 50 Oe.

8. Apparatus in accordance with one of the preceding claims, characterized in that the component of the magnetic field extending parallel to the target surface lies in the cathode sputtering process in the range from 50 to 500 Oe, in particular from 100 to 250 Oe.

9. Apparatus in accordance with one of the preceding claims, characterized in that the target surface is placed at cathode potential during the transition to magnetron operation, in order to prevent arc discharges, by a boundary ring (14) of boron nitride insulated relative to the target.

10. Apparatus in accordance with one or more of the preceding claims, characterized in that the anode is formed by the receiver of the plant.

## Revendications

1. Dispositif pour le revêtement de substrats (10) en utilisant une décharge en arc et une pulvérisation cathodique, avec un récipient (5), dans lequel le vide peut être fait, et dans lequel au moins une cible (1), une anode associée (8) et un support de substrat (9) sont agencés, les alimentations en courant et en tension associées sont prévues et un dispositif magnétique (2, 3) est associé à chaque cible (1), le dispositif magnétique étant constitué d'un aimant permanent à pôle central (2) et d'aimants permanents de bord (3) entourant celui-ci à une certaine distance et à polarisation opposée,
caractérisé en ce que l'aimant permanent à pôle central (2) est agencé par rapport à la cible (1) dans une position fixe, voisine de la cible (1), tandis que les aimants permanents de bord (3) sont montés mobiles axialement, avec une plaque de support (4), par rapport à la cible (1) et à l'aimant permanent à pôle central (2) de telle sorte que, dans la zone de la cible, dans une première position voisine de la cible (1), un champ magnétique permettant une pulvérisation cathodique ou de magnétron est produit et, dans une deuxième position à une certaine distance de la cible (1), un champ magnétique permettant la décharge en arc est produit.

2. Dispositif pour le revêtement de substrats (10) en utilisant une décharge en arc et une pulvérisation cathodique, avec un récipient (5), dans lequel le vide peut être fait, et dans lequel au moins une cible (1), une anode associée (8) et un support de substrat (9) sont agencés, les alimentations en courant et en tension associées sont prévues et un dispositif magnétique (2, 3) est associé à chaque cible (1), le dispositif magnétique étant constitué d'un aimant permanent à pôle central (2) et d'aimants permanents de bord (3) entourant celui-ci à une certaine distance et à polarisation opposée, l'aimant permanent à pôle central (2) étant conçu moins actif magnétiquement que les aimants permanents de bord (3), les aimants permanents de bord (3) et l'aimant permanent à pôle central (2) étant agencés sur une plaque de support (4) provoquant un court-circuit magnétique, la plaque de support (4) qui comporte le dispositif magnétique (2, 3) étant montée mobile par rapport à la cible correspondante (1), au moyen d'une barre de support (7) qui est reliée à la plaque de support (4) en intercalant un élément d'écartement (6) en un matériau neutre du point de vue magnétique, de telle sorte que, dans la zone de la cible, dans une première position voisine de la cible (1), un champ magnétique permettant une pulvérisation cathodique est produit et, dans une deuxième position à une certaine distance de la cible, un champ magnétique permettant la décharge en arc est produit.

3. Dispositif selon la revendication 1,
caractérisé en ce que l'aimant permanent à pôle central (2) et les aimants permanents de bord (3) sont séparés magnétiquement les uns des autres et en ce qu'un élément d'écartement (6) en un matériau neutre du point de vue magnétique est agencé à cet effet de préférence entre le support de plaque (4) et l'aimant permanent à pôle central (2).

4. Dispositif selon la revendication 1,
caractérisé en ce que l'aimant permanent à pôle central (2) est conçu moins actif magnétiquement que les aimants permanents de bord (3).

5. Dispositif selon l'une des revendications précédentes,
caractérisé en ce que la cible (1) est entourée par une bobine électromagnétique pouvant être commandée en fonction du mode de fonctionnement respectif.

6. Dispositif selon l'une des revendications précédentes,
caractérisé en ce que la distance, correspondant aux deux positions de fonctionnement, entre la cible (1) et le dispositif magnétique (2, 3) se trouve dans la plage de 10 à 20 cm.

7. Dispositif selon l'une des revendications précédentes,
caractérisé en ce que la composante, s'étendant parallèlement à la surface de la cible, du champ magnétique se trouve lors de la décharge en arc dans la plage de 10 à 250, notamment de 10 à 50 Oe.

8. Dispositif selon l'une des revendications précédentes,
caractérisé en ce que la composante, s'étendant parallèlement à la surface de la cible, du champ magnétique se trouve lors de la pulvérisation cathodique dans la plage de 50 à 500, notamment de 100 à 250 Oe.

9. Dispositif selon l'une des revendications précédentes,
caractérisé en ce que la surface de cible est mise au potentiel de cathode par un anneau de limitation en nitrure de bore (14) isolé par rapport à la cible lors du passage au fonctionnement en magnétron pour empêcher des décharges en arc.

10. Dispositif selon une ou plusieurs des revendications précédentes,
caractérisé en ce que l'anode est formée par le récipient d'installation.
